(19) Europäisches Patentamt / European Patent Office / Office européen des brevets

(11) **EP 4 481 345 B1**

(12) **EUROPÄISCHE PATENTSCHRIFT**

(45) Veröffentlichungstag und Bekanntmachung des Hinweises auf die Patenterteilung:
**18.02.2026   Patentblatt 2026/08**

(21) Anmeldenummer: **24179178.9**

(22) Anmeldetag: **31.05.2024**

(51) Internationale Patentklassifikation (IPC):
**B81B 3/00** *(2006.01)*         **G01P 21/00** *(2006.01)*
**G01P 15/125** *(2006.01)*       **G01L 1/14** *(2006.01)*
**G01B 5/30** *(2006.01)*         **G01B 7/16** *(2006.01)*
**G01L 1/22** *(2006.01)*

(52) Gemeinsame Patentklassifikation (CPC):
**B81B 3/0086; B81B 3/0078; G01B 5/30; G01B 7/22; G01L 1/148; G01L 1/2293; G01P 15/125; G01P 15/131; G01P 21/00;** B81B 2201/0235; B81B 2201/0242; B81B 2201/0278; B81B 2201/0292; B81B 2201/033; B81B 2201/037

(54) **VORRICHTUNG UND VERFAHREN ZUR ANPASSUNG VON MESSBEREICH UND SENSITIVITÄT VON MIKROMECHANISCHEN SENSOREN**

DEVICE AND METHOD FOR ADAPTING MEASUREMENT RANGE AND SENSITIVITY OF MICROMECHANICAL SENSORS

DISPOSITIF ET PROCÉDÉ D'ADAPTATION DE PLAGE DE MESURE ET DE SENSIBILITÉ DE CAPTEURS MICROMÉCANIQUES

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **01.06.2023   DE 102023114462**

(43) Veröffentlichungstag der Anmeldung:
**25.12.2024   Patentblatt 2024/52**

(73) Patentinhaber: **Ruhr-Universität Bochum**
**44801 Bochum (DE)**

(72) Erfinder:
• **Schmitt, Philip**
  **44801 Bochum (DE)**
• **Hoffmann, Prof. Dr. Martin**
  **44879 Bochum (DE)**

(74) Vertreter: **Michalski Hüttermann & Partner Patentanwälte mbB**
**Kaistraße 16A**
**40221 Düsseldorf (DE)**

(56) Entgegenhaltungen:
• **KHAN SAMBUDDHA ET AL: "Improving the Sensitivity and Bandwidth of In-Plane Capacitive Microaccelerometers Using Compliant Mechanical Amplifiers", JOURNAL OF MICROELECTROMECHANICAL SYSTEMS, IEEE SERVICE CENTER, US, vol. 23, no. 4, 1 August 2014 (2014-08-01), pages 871 - 887, XP011554923, ISSN: 1057-7157, [retrieved on 20140729], DOI: 10.1109/JMEMS.2014.2300231**
• **WANG CHEN ET AL: "A Mems Accelerometer with an Auto-Tuning System Based on an Electrostatic Anti-Spring", 2021 IEEE 34TH INTERNATIONAL CONFERENCE ON MICRO ELECTRO MECHANICAL SYSTEMS (MEMS), IEEE, 25 January 2021 (2021-01-25), pages 184 - 187, XP033887033, DOI: 10.1109/ MEMS51782.2021.9375285**

# EP 4 481 345 B1

**Beschreibung**

Die Erfindung betrifft ein Sensorsystem und ein zugeordnetes Verfahren zur Anpassung des Messbereichs und zur Erhöhung der Sensitivität eines mikromechanischen Sensors. Die Vorrichtung kann insbesondere in mikromechanischen Dehnungssensoren, Beschleunigungssensoren oder Temperatursensoren integriert werden. Die Erfindung ermöglicht im Besonderen mit einem mikromechanischem Sensorelement einen breiten Messbereich zu erfassen und gleichzeitig die Messauflösung schrittweise zu erhöhen.

Mikromechanisch-elektrische Sensoren, auch als MEMS (Micro Electro-Mechanical System) Sensoren bezeichnet, umfassen typischerweise eine chipbasierte Technologie, bei der die Sensoren meist aus einer aufgehängten Masse zwischen einem Paar kapazitiver Platten bestehen. Wenn der Sensor bewegt oder beispielsweise gekippt wird, wird durch diese aufgehängten Masse ein Unterschied im elektrischen Potenzial erzeugt. Diese Differenz wird dann als Kapazitätsänderung gemessen.

Sensoren jeglicher Art besitzen eine Kennlinie, welche approximativ ihre wesentliche (Mess-)Charakteristik darstellen, dass heißt die Antwortfunktion auf eine bestimmte Eingangs- oder Messgröße darstellen. Diese Kennlinie, allgemein repräsentiert durch eine Geradengleichung, bspw. in Form von $y(x)=a*x+b$, verhält sich nicht immer ideal zur durchzuführenden Messung. Die Sensivität entspricht dem Parameter a für die Steigung und der Offset entspricht dem y-Achsen-Abschnitt mit dem Parameter b. Eine Anpassung der Kennlinie an einen aktuell vorliegenden Messbereich ermöglicht im Allgemeinen eine Steigerung der Messgenauigkeit.

Die Einstellung der Sensivität und des Messbereichs beispielsweise bei Dehnungs- oder Beschleunigungssensoren erfolgt meist elektronisch durch die Signalverarbeitung oder Auswerteelektronik, beispielsweise durch Erhöhung der Auflösung eines Analog-Digital-Umsetzers oder durch eine Veränderung des Verstärkungsfaktors an einem Instrumentenverstärker. Die Einstellung der Sensivität erfolgt somit erst am bereits erfassten und umgewandelten Signal. Zur Erhöhung des erfassbaren Messbereiches wurden bislang mehrere Sensorelemente mit unterschiedlichen, insbesondere benachbarten Messbereichen verwendet oder es erfolgte ein physischer Austausch des Sensorelements.

Die EP 3 822 577 A1 beschreibt einen MEMS-Sensor, welcher zur mechanischen Dehnungsmessung über zwei Verbindungselemente, deren Verschiebung über einen mechanischen Verstärker verstärkt und über einen elektromechanischen Wandler in eine elektrische Größe gewandelt wird.

Der Artikel "Improving the Sensitivity and Bandwidth of In-Plane Capacitive Microaccelerometers Using Campliant Mechanical Amplifiers" aus dem Journal of Microelectromechanical systems, doi: 10.1109/JMEMS.2014.2300231, beschreibt eine Methode, mit der sowohl die Empfindlichkeit als auch die Bandbreite von kapazitiven mikromechanischen Beschleunigungssensoren in der Ebene verbessert werden kann, indem nachgiebige mechanische Verstärker verwendet werden und somit der Kompromiss zwischen Empfindlichkeit und Bandbreite vermieden wird.

Der Artikel "A Mems Accelerometer with an Auto-Tuning System based on an electrostatic anti-spring" der 2021 IEEE 34th international conference on micro electro mechanical systems (MEMS), doi: 10.1109/MEMS51782.2021.9375285, beschreibt einen MEMS-Beschleunigungsmesser mit einem Autotuning-System, das auf einer elektrostatischen Antifeder basiert. Die Empfindlichkeit des Beschleunigungssensors kann automatisch eingestellt werden, um den dynamischen Bereich und die Bandbreite entsprechend den Beschleunigungseingaben zu ändern.

Daher ist es die Aufgabe der Erfindung, ein Sensor- oder Messsystem bereitzustellen, mit dem die vorgenannten Nachteile vermieden werden und insbesondere die Messgenauigkeit oder der Messbereich und/oder die Sensitivität eines MEMS-Sensors verbessert werden.

Diese Aufgabe wird durch eine Vorrichtung nach Anspruch 1 und ein Verfahren nach Anspruch 13 gelöst. Bevorzugte Weiterbildungen finden sich in den Unteransprüchen.

Das im Rahmen der Erfindung umgesetzte Messprinzip zielt darauf ab, den Messbereich und/oder die Sensivität direkt bei der Erfassung des Signals mit der Hardware und somit durch das Sensorelement an sich anzupassen, das heißt die Sensoreigenschaften des erfassenden Elements an sich werden verändert.

Erfindungsgemäß wird ein Messsystem auf Basis von mikromechanischen Elementen bereitgestellt, umfassend einen Energiewandler, welcher dazu eingerichtet ist, ein physikalisches Signal in eine Verschiebung des Energiewandlers umzuwandeln, einen Kraftgenerator und einen bewegbar gelagerten Läufer, welche dazu eingerichtet sind, die Verschiebung vom Energiewandler in eine Kraft auf den bewegbar gelagerten Läufer umzuwandeln, und eine elektrostatische Anti-Feder, welche mechanisch mit dem Läufer verbunden ist, und einen elektromechanischen Signalwandler, der eine Verschiebung des Läufers in ein elektrisches Signal umwandelt, wobei die elektrostatische Anti-Feder dazu eingerichtet ist, über eine Steuerspannung eine Sensivität des Messsystems einzustellen.

Die Steuerspannung ermöglicht eine Verschiebung der Messsystem-Charakteristik und somit dessen Anpassung an einen jeweiligen Einsatzfall für eine Steigerung des Messbereiches und/oder die Genauigkeit und/oder die Sensivität eines MEMS-basierten Messsystems.

Ein Läufer bezeichnet insbesondere ein mechanisches Element, welches beweglich aufgehängt oder gelagert ist und Kräfte oder Bewegungen weiterleiten kann.

Die Vorteile der Erfindung lassen sich wie folgt zusammenfassen: Die Sensitivität eines mikromechanischen Sensors lässt sich folglich über das Anlegen einer Spannung einstellen. Der Messbereich lässt sich zudem durch Anlegen einer Spannung verschieben.

Spezielle Vorteile für die Umsetzung eines Dehnungssensors sind die Dehnungsmessung über einen einzigen Chip und es ist keine aufwendige elektrische Verstärkerschaltung notwendig. Die Erfindung ermöglicht zudem eine starke Reduktion der zusätzlich benötigten Auswertelektronik.

Auch sind keine parasitären elektrischen Effekte wie elektrisches Rauschen oder hohe Quersensitivität in Bezug auf Temperaturänderungen möglich, da ein rein mechanisches Prinzip ohne Widerstand vorliegt. Die erfindungsgemäßen Sensoren oder Messsysteme ermöglichen auch eine Wafer-Level Fertigung der Sensorchips und folglich eine Massenfertigung und damit eine kostengünstige Fertigung. Auch ist keine Stück-Kalibrierung erforderlich oder eine Trimmung wie beim Trimmen des Grundwiderstands bei einem Dehnungsmessstreifen (DMS).

Die Erfindung umfasst insbesondere ein Messsystem aus einem Energiewandler wie z.B. einer seismischen Masse, einem Kraftgenerator, einem mechanischen Verstärkungsmechanismus, einer elektrostatischen Anti-Feder und optional einem Aktor zur Offsetkompensation sowie einem elektromechanischen Wandler. Der Energiewandler ist dabei dazu ausgeführt, ein physikalisches Signal (z. B. Druck, Dehnung, Beschleunigung, Temperatur etc.) in eine Verschiebung zu wandeln. Der Kraftgenerator, beispielsweise in Form einer Feder, wandelt diese Verschiebung schließlich in eine Kraft um. Gegenkräfte seitens der elektrostatischen Anti-Feder, dem Aktor zur Offsetkompensation sowie die Gegenkräfte weiterer optionaler Führungsfedern reduzieren oder erhöhen die Auslenkung am Kraftgenerator. Die resultierende Verschiebung des Kraftgenerators wird typischerweise durch einen mechanischen Verstärker verstärkt und indirekt oder direkt schließlich an den elektromechanischen Signalwandler übergeben, der die Verschiebung in ein elektrisch auswertbares Signal wandelt, beispielsweise in eine Kapazitätsänderung. Die genaue Anordnung der Komponenten kann dabei variieren.

In einer bevorzugten Ausführungsform ist die elektrostatische Anti-Feder bidirektional und/oder weist variierende Elektrodenabstände auf. Variierende Elektrodenabstände erlauben insbesondere über die Einstellung der Steuerspannung eine Veränderung der Sensitivität des gesamten Messsystems. Bidirektional bedeutet insbesondere, dass die Eigenschaften der Anti-Feder für beide Bewegungs- oder Translationsrichtungen nahezu gleichwertig sind.

In einer weiteren bevorzugten Ausführungsform ist die elektrostatische Anti-Feder als symmetrischer elektrostatischer Kammantrieb mit Paaren von gekrümmten und ggf. zusätzlichen parallelen Plattenelektroden ausgebildet. Insbesondere die Kombination von gekrümmten und parallelen Plattenelektroden erlaubt eine vorteilhafte Einstellung der Sensitivität des Messsystems über die Steuerspannung.

Bei einer bevorzugten Realisierung des Messsystems ist der Läufer mit einem elektrostatischen Aktor verbunden, wobei der elektrostatische Aktor dazu eingerichtet ist, über eine Steuerspannung eine Offsetkompensation des Messsystems einzustellen. Die Steuerspannung am Aktor ermöglicht somit eine zusätzliche Verschiebung der Messsystem-Charakteristik und somit eine weitere Möglichkeit zur Anpassung an einen jeweiligen Einsatzfall, insbesondere für eine Veränderung des Messbereiches und/oder die Genauigkeit und/oder die Sensitivität eines MEMS-basierten Messsystems.

In einer ganz besonders bevorzugten Ausführungsform ist der elektrostatische Aktor als symmetrischer elektrostatischer Kammantrieb mit Paaren von parallelen Plattenelektroden ausgebildet ist. Die Charakteristik eines Kammantriebs mit Paaren von parallelen Plattenelektroden erlaubt dabei eine relativ einfache Einstellung oder Korrektur eines konstanten Offsets für das Messsystem mittels einer anzulegenden Steuerspannung.

Bevorzugt ist der Läufer mit einem mikromechanischen Verstärker verbunden. Der mikromechanische Verstärker kann eine Translation oder Verschiebung in seiner Amplitude vergrößern, insbesondere durch eine Reihenschaltung von Hebeln. Insbesondere wandelt der mikromechanische Verstärker eine eingangsseitige translatorische Bewegung mittels einer Reihenschaltung von Hebeln ausgangsseitig in eine Amplituden-verstärkte translatorische Verschiebung um.

In einer besonderen Ausführungsform weist der Läufer einen Rückstellmechanismus auf. Dieser kann insbesondere elektromechanisch, aber auch rein mechanisch, beispielsweise über Federelemente, realisiert werden.

Insbesondere wird der Läufer mittels Führungsfedern gehalten. Dies ermöglicht ebenfalls eine schwebende und/oder bewegliche Aufhängung des Läufers.

Bevorzugt basiert der elektromechanische Signalwandler auf einer Kapazitätsänderung, wie dies insbesondere bei Kamm-artigen MEMS-Strukturen der Fall ist und stark überwiegend Anwendung findet.

Der Kraftgenerator kann in einfacher Weise über eine mechanische Feder realisiert werden. Denkbar sind auch elektromechanische Realisierungsformen zur Umwandlung eines physikalischen Signals insbesondere in eine Translation und/oder Verschiebung.

In einer einfachen Ausführungsform ist der Läufer ein starres mechanisches Element, beispielsweise ein einfacher Stab, an welchem weitere mechanische oder MEMS-Elemente angekoppelt sein können.

In einer ganz besonders bevorzugten Ausführungsform umfasst die Erfindung einen Computer, welcher dazu eingerichtet ist, die Offsetkompensation und/oder die Einstellung der Sensitivität durchzuführen. Hierzu muss der

Computer Signale des Messsystems erfassen, auswerten und die jeweilige Steuerspannung entsprechend einstellen. Hierdurch können die Einstellungen insbesondere automatisiert erfolgen.

Die Erfindung umfasst zudem ein Verfahren zur Anpassung des Messbereichs und/oder Erhöhung der Sensitivität eines mikromechanischen Messsystems, mit den Schritten: Umwandeln eines physikalischen Signals in eine Verschiebung und/oder Translation mittels eines Energiewandlers, Umwandeln der Verschiebung und/oder Translation vom Energiewandler in eine Kraft auf einen bewegbar gelagerten Läufer mittels eines Kraftgenerators, und Umwandeln der Verschiebung und/oder Translation des Läufers in ein elektrisches Signal mittels eines elektromechanischen Signalwandlers, wobei die Sensitivität des Messsystems über eine Steuerspannung einer elektrostatischen Anti-Feder eingestellt wird, welche mit dem Läufer und/ oder dem Kraftgenerator verbunden ist. Das Verfahren kann zudem auch vorsehen, dass eine Offsetkompensation des Messsystems über eine Steuerspannung eines elektrostatischen Aktors eingestellt wird, wobei der Aktor ebenfalls mit dem Läufer und/oder dem Kraftgenerator verbunden ist. Die Steuerspannung am Aktor ermöglicht dann eine zusätzliche Verschiebung der Messsystem-Charakteristik und somit eine weitere Möglichkeit zur Anpassung an einen jeweiligen Einsatzfall.

Bevorzugt umfasst das Verfahren die Schritte Messen mittels mikromechanischem Messsystem, Durchführung einer Offsetkompensation, Erhöhung der Sensitivität und ein wiederholtes Messen mittels des Messsystems. Hierdurch kann eine iterative Verbesserung der Messgenauigkeit oder des Messbereiches und/oder der Sensitivität eines MEMS-Sensors oder MEMS-basierten Messsystems erreicht werden.

Die Erfindung umfasst ferner die Verwendung des vorbeschriebenen mikromechanischen Messsystems nach einem der vorherigen Ansprüche in einem Dehnungssensor oder Beschleunigungssensor oder Temperatursensor.

Nachfolgend wir die Erfindung anhand eines bevorzugten Ausführungsbeispiels unter Bezugnahme auf die Zeichnungen weiter im Detail erläutert.

In den Zeichnungen zeigen

Fig. 1 ein schematisches Grundprinzip zur iterativen Verbesserung eines Messsystems gemäß einen bevorzugten Ausführungsbeispiel der Erfindung,

Fig. 2 eine Illustration des Grundprinzips zur iterativen Verbesserung eines erfindungsgemäßen Messsystems anhand von Kennlinien des Messsystems,

Fig. 3 ein bevorzugtes Ausführungsbeispiel der Erfindung mit einem Dehnungsmesssensor,

Fig. 4 Ersatzschaubilder zur Illustration der vorliegenden Kräfte,

Fig. 5 weitere Ersatzschaubilder zur Illustration der vorliegenden Kräfte,

Fig. 6 eine weitere Ausführungsform des Sensors mit geänderter Anordnung des Kraftgenerators,

Fig. 7 ein bevorzugtes Ausführungsbeispiel einer elektrostatischen Anti-Feder,

Fig. 8 ein weiteres bevorzugtes Ausführungsbeispiel einer elektrostatischen Anti-Feder und

Fig. 9 ein bevorzugtes Ausführungsbeispiel der Erfindung mit einem Beschleunigungssensor.

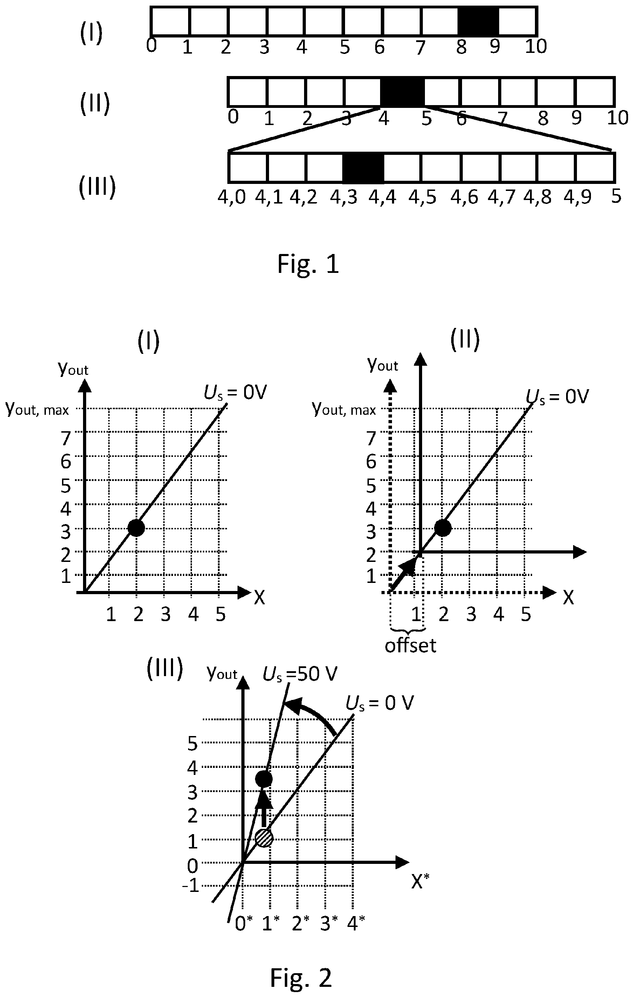

Die Figur 1 zeigt zunächst einen grundlegenden Ansatz zur Verbesserung der Messeigenschaften eines mikromechanischen Messsystems 1. Das Messsystem 1 ist zunächst für einen sehr breiten Messbereich ausgelegt oder konfiguriert. Zunächst erfolgt in Schritt 1 eine grobe Messung bei einem breiten Messbereich. Anschließend wird in einem zweiten Schritt der Messbereich so verschoben, dass der ermittelte Messwert ungefähr in der Mitte des neuen Messbereichs liegt. In einem dritten Schritt wird die Sensitivität des Sensors erhöht, sodass der Messwert genauer auflöst wird. Die Erfindung nutzt für die Verschiebung des Messbereichs (Schritt 2) und die Erhöhung der Sensitivität (Schritt 3) mikromechanische Bauelemente, sodass die Anpassungen mechanisch direkt am Chip erfolgen.

Das Grundkonzept der Vorrichtung wird im Folgenden am Beispiel eines Dehnungssensors erläutert und zunächst in Figur 2 illustriert. Dabei handelt es sich im Besonderen um einen mikromechanischen Dehnungssensor auf Silicium-Basis. Der Dehnungssensor wird z.B. in Form eines Chips stoffschlüssig auf ein Prüfobjekt montiert und erfasst die am Objekt vorliegende Dehnung und wandelt diese in ein elektrisch auswertbares Signal um, insbesondere in eine Kapazitätsänderung. Eine wesentliche Eigenschaft des Dehnungssensors besteht darin, dass durch das Anlegen von mindestens einer Steuerspannung an einem erfindungsgemäßen Sensor der Messbereich und/ oder die Sensitivität beeinflusst werden können.

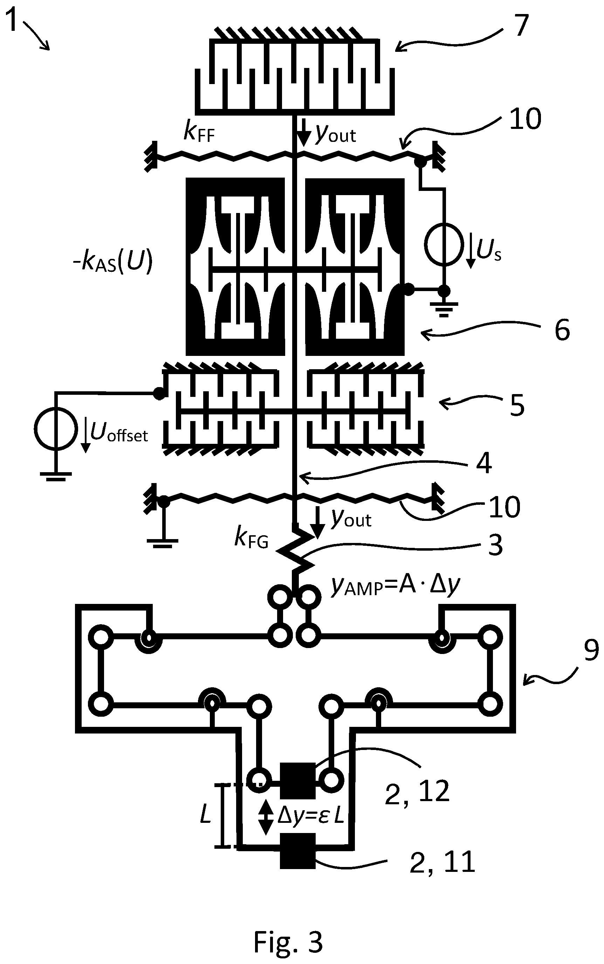

In einem ersten Schritt wandelt der Sensor zunächst das Messsignal X - hier in Form einer Dehnungsamplitude - in ein Verschiebungssignal $y_{out}$ um. Das Verschiebungssignal dient als Ausgabegröße des Sensors und kann in Folge der Datenerfassung über einen Encoder codiert oder über einen kapazitiven Wandler in eine Kapazitätsänderung überführt werden. Für eine unbekannte Dehnungsamplitude ist es sinnvoll, einen möglichst großen Messbereich mit dem Sensor abzudecken und so zunächst die grobe Amplitude der Messgröße X (hier Dehnung) zu bestimmen. Hier ist der Messbereich auf einen relativ hohen Dehnungswert von z. B. 5% begrenzt. Nachdem die grobe Dehnungsamplitude in einem ersten Schritt bestimmt wurde (s. Fig. 3, I), wird in Schritt 2 über eine Steuerspannung $U_{offset}$ der Offset ausgeglichen und damit der Messbereich so verschoben, dass der Messwert nun mitten oder annähernd mittig im Messbereich des angepassten Sensors liegt. Folglich können Messwerte, die zuvor am Rand oder sogar außerhalb des ursprünglich definierten Messbereichs liegen, erfasst werden. In Schritt 3 wird durch Anlegen einer weiteren Steuerspannung $U_S$ die Sensitivität oder Empfindlichkeit des Sensors erhöht, um nach der groben Messung aus Schritt 1 nun eine genauer aufgelöste Messung umzusetzen.

Figur 3 zeigt eine mögliche Ausführungsform des Dehnungssensors. Die Vorrichtung umfasst einen mechanischen Differenzverstärker 9 mit zwei Kontaktpunkten 11, 12, einen Kraftgenerator 3 in Form einer Feder, einen elektrostatischen Aktor 5 zur Offsetkompensation, eine elektrostatische Anti-Feder 6 und einen elektromechanischen Signalwandler 7. Zur Erfassung einer Dehnung wird der Sensor über die Kontaktpunkte -1- und -2- mit dem Prüfobjekt verbunden. Die Dehnung ε des Prüfobjektes wird somit über die Kontaktpunkte in den Sensor eingekoppelt. Dabei führt eine Dehnung am Prüfobjekt zu einer relativen Verschiebung der beiden Kontaktpunkte zueinander. Der mechanische Differenzverstärker 9 verstärkt die relative Verschiebung $\Delta y$ um einen Verstärkungsfaktor A und leitet die verstärkte Verschiebung $y_{AMP}$ in einen Kraftgenerator 3 - hier eine Feder - ein. Die verstärkte Verschiebung wird durch Gegenkräfte der Führungsfedern 10 reduziert, wobei der Kraftgenerator 3 in Form einer Feder gestaucht wird und lediglich eine reduzierte Verschiebung $y_{out} < y_{AMP}$ an den Läufer 4 weitergibt.

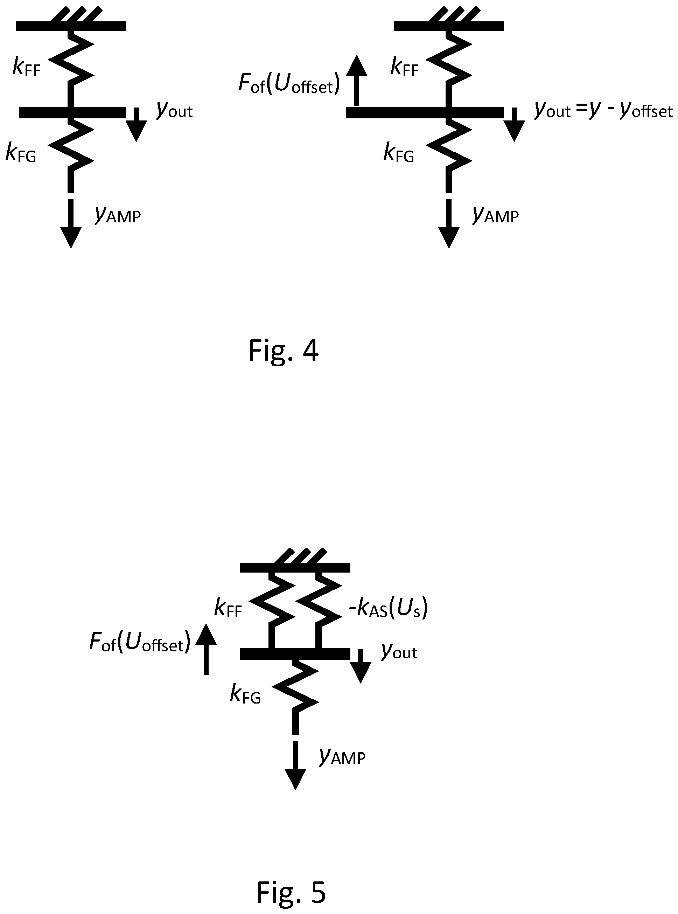

Das Ersatzschaltbild in Figur 4 (links) verdeutlicht die wirkenden Federn und die resultierende Verschiebung. Für die Verschiebung ergibt sich in Abhängigkeit der Federkonstanten $k_{FG}$ (Kraftgenerator (3)) und $k_{FF}$ (Führungsfedern 10):

$$y_{\text{out}} = y_{\text{AMP}} \frac{k_{\text{FG}}}{k_{\text{FG}} + k_{\text{FF}}}$$

Mit steigender Steifigkeit der Führungsfedern $k_{FF}$ reduziert sich folglich die Ausgangsverschiebung $y_{out}$ und somit die Sensitivität.

Sofern der elektrostatische Aktor 5 zur Offsetkompensation und die elektrostatische Anti-Feder 6 deaktiviert sind, d. h. sofern an ihnen keine Spannung angelegt ist, wird die Verschiebung $y_{out}$ an den elektromechanischen Signalwandler 7 übergeben.

Der Signalwandler 7 übersetzt die Verschiebung $y_{out}$ in die Änderung einer elektrischen Zustandsgröße, zumeist eine Kapazitätsänderung. Der Sensor deckt nun einen breiten Messbereich bei geringer Sensitivität ab. Befindet sich nun der ermittelte Messwert am Rand oder etwas außerhalb des Messbereiches, so wird der elektrostatische Aktor 5 zur Offsetkompensation durch Anlegen einer Spannung aktiviert. In Abhängigkeit der Spannung $U_{offset}$ wird der Messbereich verschoben. Eine Verschiebung des Messbereichs entspricht hier einer mechanischen Verschiebung des Läufers 4. Der Aktor zur Offsetkompensation generiert hierzu eine konstante Kraft $F_{of}$ in Abhängigkeit der angelegten Spannung die am Kraftgenerator 3 eingeprägt wird, wodurch $y_{out}$ um einen Offset verschoben wird, siehe Figur 4 rechts. Es gilt vereinfacht:

$$y_{\text{out}} = y_{\text{AMP}} \frac{k_{\text{FG}}}{k_{\text{FG}} + k_{\text{FF}}} \pm F_{\text{of}}(U_{\text{offset}})(k_{\text{FG}} + k_{\text{FF}})$$

Je nach Richtung der Kraft $F_{of}$ wird die Verschiebung $y_{out}$ um den Offset reduziert oder erhöht.

Wird nun auch noch die elektrostatische Anti-Feder 6 aktiviert, ergibt sich das Ersatzschaltbild in Figur 5.

Die Federsteifigkeit der Führungsfeder $k_{FF}$ wird nun durch die negative Federsteifigkeit - $k_{AS}(U_s)$ der elektrostatischen Anti-Feder reduziert. Somit sinkt die rückstellende Gegenkraft der Führungsfedern und $y_{out}$ erreicht höhere Verschiebungen in Abhängigkeit der eingeprägten Dehnung. Folglich steigt die Sensitivität. Für die Ausgangsverschiebung gilt dann vereinfacht:

$$y_{\text{out}} = y_{\text{AMP}} \frac{k_{\text{FG}}}{k_{\text{FG}} + k_{\text{FF}} - k_{\text{AS}}(U_S)} \pm F_{\text{of}}(U_{\text{offset}})(k_{\text{FG}} + k_{\text{FF}} - k_{\text{AS}}(U_S))$$

Somit lässt sich zum einen der Messbereich über die Offsetspannung $U_{offset}$ als auch die Sensitivität der Messung über $U_S$ einstellen.

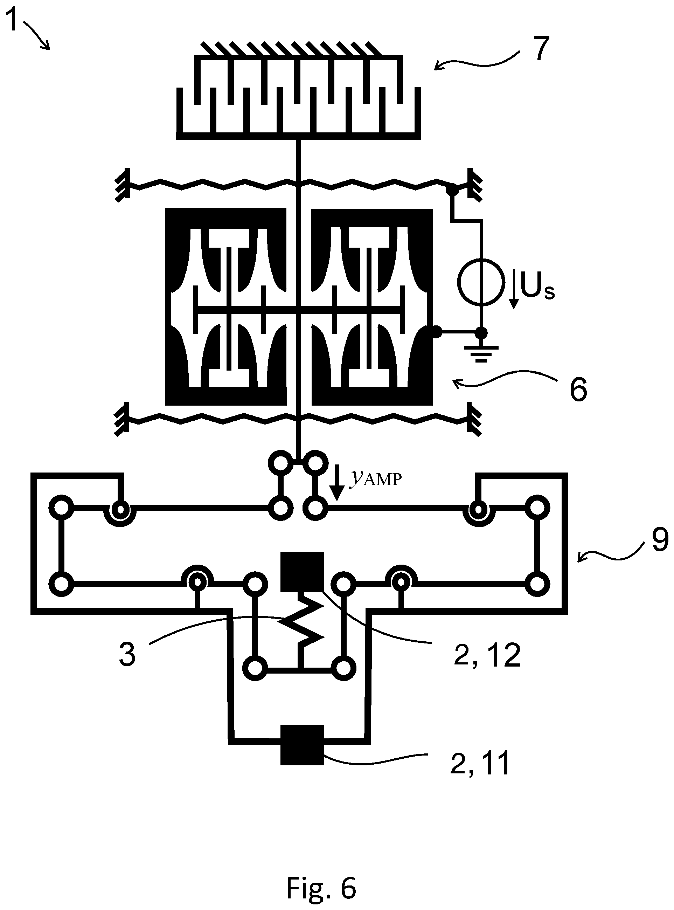

Figur 6 zeigt eine weitere Ausführungsform des Dehnungssensors mit geänderter Anordnung des Kraftgenerators 3 und ohne elektrostatischem Aktor 5 zur Offsetkompensation. Der Kraftgenerator 3 wird in der Wirkfolge vor den Verstärker 9 verschoben. Die Kompensation der Steifigkeit durch die Anti-Feder findet hier am Kraftgenerator also vor der Wegverstärkung statt. Durch den Hebelverstärker wird die eingestellte Steifigkeit an der Anti-Feder um das Quardrat des Verstärkungsfaktors A verstärkt und wirkt so in besonders hohem Maße am Kraftgenerator 3.

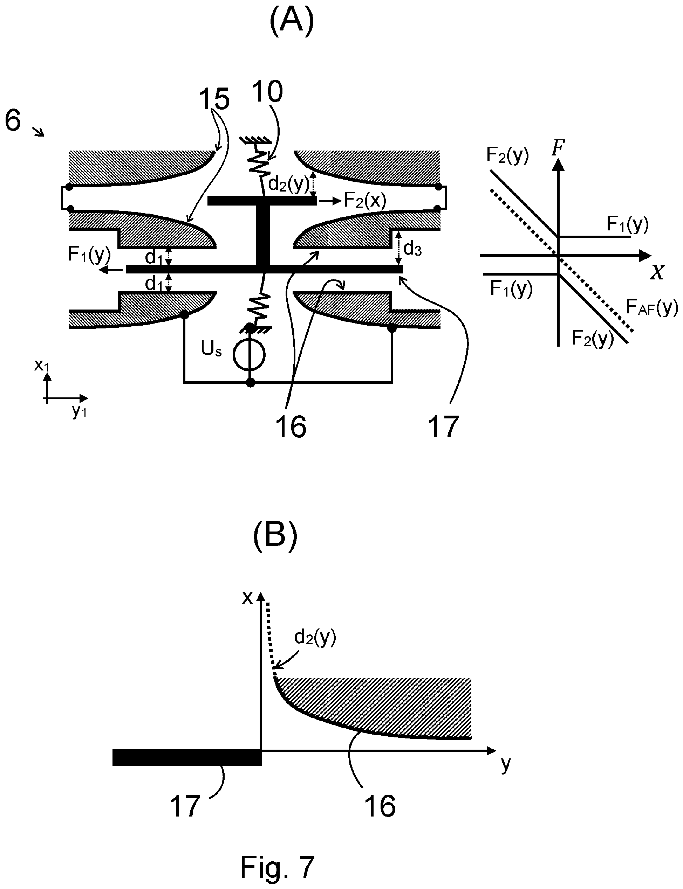

Eine bevorzugte Ausführungsform der elektrostatischen Anti-Feder wird in Figur 7A gezeigt. Die Konfiguration umfasst eine symmetrische Paarung aus festen gekrümmten Elektroden 15 und festen parallelen Elektroden 16 die auf einem gemeinsamen ersten elektrischen Potential (z.B. Masse) liegen. Weiterhin werden bewegliche innere Elektroden 17 benötigt, die mit einem zweiten elektrischen Potential (z.B. $U_s$) beaufschlagt sind. Der Elektrodenabstand $d_2(y)$ zwischen innerer Elektrode 17 und gekrümmter Elektrode 15 variiert in Abhängigkeit der Verschiebung y der beweglichen Elektrode. An der Anti-Feder wird in Abhängigkeit der Verschiebung y und der angelegten Spannung $U_s$ eine elektrostatische Kraft $F_{AF}(y,U_s)$ generiert. Sie ist zusammengesetzt aus der elektrostatischen Kraft an der gekrümmten Elektrode $F_2(y,U_s)$ und der Kraft $F_1(y,U_s)$ an der parallelen Elektrode:

$$F_{\mathrm{AF}}(y,U_s) = F_1(y,U_s) - F_2(y,U_s)$$

Beide einzelnen Kräfte wirken in entgegengesetzter Richtung. Die parallelen Elektroden 16 werden genutzt, um einen möglichen Offset der elektrostatischen Kraft $F_2(y,U_s)$ innerhalb der Anti-Feder zu kompensieren, wie das Diagramm in Figur 7A rechts zeigt.

Für die Kraft $F_{AF}(y,U_s)$ gilt weiterhin:

$$F_{\mathrm{AF}}(y,U_s) = \frac{\varepsilon_0\, t}{d_1}\, U_s^2 - \frac{\varepsilon_0\, t}{d_2(y)}\, U_s^2$$

Wobei der Parameter t hier die Dicke der Elektroden in z-Richtung und $\varepsilon_0$ die Permittivität berücksichtigt. Fig. 7B zeigt eine gekrümmte Elektrode 15 im Detail. Die Elektroden 15 sind so ausgelegt, dass für den Elektrodenabstand $d_2(y)$ mit dem Proportionalitätsfaktor $a$ und dem Verschiebungsfaktor b die folgende Beziehung gilt:

$$d_2(y) = \frac{a}{y + b}$$

Für den konstanten Abstand $d_1$ zwischen innerer Elektrode 17 und paralleler Elektrode 16 gilt weiterhin:

$$d_1 = \frac{a}{b}$$

Durch die Ableitung der Kraft $F_{AF}(y,U_s)$ nach der Verschiebung y ergibt sich somit die elektrostatische Steifigkeit der Anti-Feder $k_{AF}(U_s)$ in Abhängigkeit der angelegten Spannung Us zu:

$$k_{\mathrm{AF}}(U_s) = -\frac{\varepsilon_0\, t}{a}\, U_s^2.$$

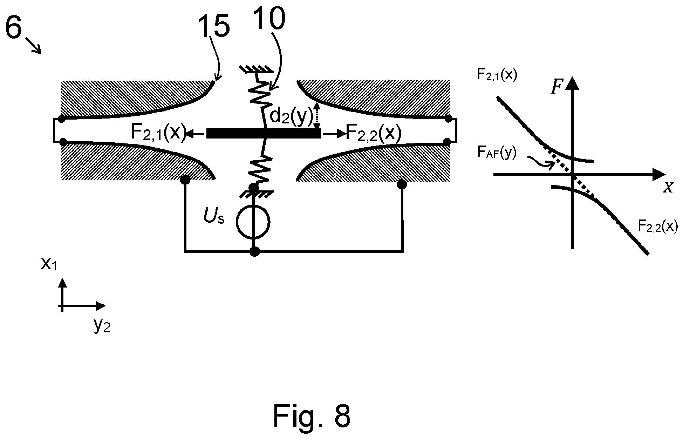

Figur 8 zeigt eine weitere bevorzugte Ausführungsform der elektrostatischen Anti-Feder. Anstelle zusätzlicher paralleler Elektroden 16 wird hier das Streufeld am Rande der gekrümmten Elektroden 15 genutzt, um einen möglichen Offset der elektrostatischen Kräfte zu kompensieren (s. Diagramm in Figur 8 rechts).

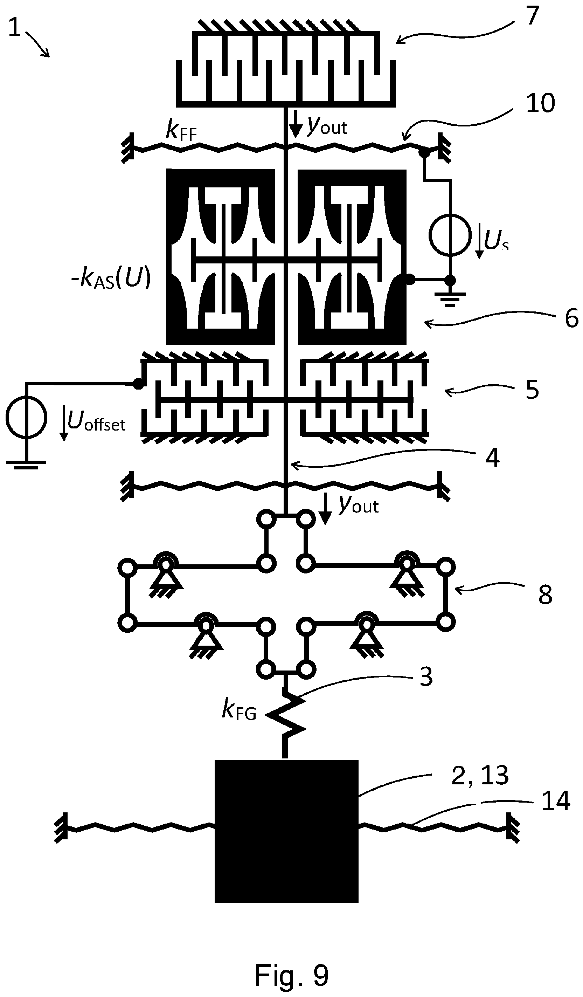

Die Figur 9 zeigt ein weiteres Ausführungsbeispiel eines Sensors mit anpassbarer Sensitivität und Messbereich. Anstelle einer Dehnung wird hier eine Beschleunigung erfasst. Hierzu umfasst der Sensor nun anstelle der Kontaktpunkte eine seismische Masse 13 die über Federn 14 fest aufgehangen ist und die über den Kraftgenerator 3 mit dem Eingang eines mechanischen Verstärkermechanismus verbunden ist.

Üblicherweise werden Beschleunigungssensoren entsprechend der erwarteten Beschleunigung ausgewählt, sodass der Messbereich des Sensors die erwartete Beschleunigung abdeckt. Mit zunehmender Größe des Messbereichs sinkt dann jedoch im Allgemeinen die Auflösung des Sensors oder Messsystems 1.

Wird eine Beschleunigung von 100,4g erwartet, kommt beispielsweise ein 6 Bit Sensor mit einem Messbereich von 0 bis 128g zur Anwendung. Der erwartete Messwert liegt also am Rand des Messbereichs. Die Auflösung des Sensors entspricht 2g/Bit (=128g/$2^6$). Das heißt der Messwert von 100,4g wird nichtvollständig aufgelöst, sondern liegt zwischen den auflösbaren Messwerten von 100g und 102g Bei einer äquivalenten Ausführung des Sensors mit der erfindungsgemäßen Vorrichtung wird bei gleichem Messbereich von 0 bis 128g zunächst der Messwert von 100g$\pm$2g grob erfasst. Nun wird der Messbereich jedoch verschoben, so dass der Wert 100 g in der Mitte des Messbereichs liegen. Der Messbereich liegt dann also zwischen 36g und 164g. Nun wird die Sensitivität durch die Anti-Feder 6 erhöht also z.B. verzehnfacht, wodurch ebenfalls der Messbereich eingeschnürt wird. Der Messbereich liegt nun zwischen 94g und 106g. Die 6 Bit Auflösung des Sensors bewirken nun eine Auflösung und Schrittweite von 0,2 g/Bit (=12,8g/$2^6$). Der Messwert von 100,4g kann nun bei gleicher Bittiefe aufgelöst werden.

Bezugszeichenliste

| | |
|---|---|
| 1 | Messsystem |
| 2 | Energiewandler |
| 3 | Kraftgenerator |
| 4 | Läufer |
| 5 | elektrostatischer Aktor |
| 6 | elektrostatische Anti-Feder |
| 7 | elektromechanischer Signalwandler |
| 8 | mikromechanischer Verstärker |
| 9 | Mechanischer Differenzverstärker |
| 10 | Führungsfeder |
| 11 | Kontaktpunkt 1 |
| 12 | Kontaktpunkt 2 |
| 13 | Seismische Masse |
| 14 | Feder |
| 15 | gekrümmte Elektrode einer bevorzugten Ausführung der Anti-Feder |
| 16 | parallele Elektrode einer bevorzugten Ausführung der Anti-Feder |
| 17 | bewegliche Elektrode einer bevorzugten Ausführung der Anti-Feder |

**Patentansprüche**

1. Messsystem (1) auf Basis von mikromechanischen Elementen, umfassend

   - einen Energiewandler (2), welcher dazu eingerichtet ist, ein physikalisches Signal in eine Verschiebung des Energiewandlers (2) umzuwandeln,
   - einen Kraftgenerator (3) und einen bewegbar gelagerten Läufer (4), welche dazu eingerichtet sind, die Verschiebung vom Energiewandler (2) in eine Kraft auf den bewegbar gelagerten Läufer (4) umzuwandeln, und
   - einen elektromechanischen Signalwandler (7), der eine Verschiebung des Läufers (4) in ein elektrisches Signal umwandelt, **dadurch gekennzeichnet, dass**
   das Messsystem eine elektrostatische Anti-Feder (6) umfasst, welche mechanisch mit dem Läufer (4) verbunden ist,
   wobei die elektrostatische Anti-Feder (6) dazu eingerichtet ist, über eine Steuerspannung eine Sensitivität des Messsystems (1) einzustellen.

2. Messsystem nach Anspruch 1, wobei die elektrostatische Anti-Feder (6) bidirektional ist und/oder variierende Elektrodenabstände aufweist.

3. Messsystem nach Anspruch 1 oder 2, wobei die elektrostatische Anti-Feder (6) als symmetrischer elektrostatischer Kammantrieb mit Paaren von gekrümmten und parallelen Plattenelektroden ausgebildet ist.

4. Messsystem nach einem der vorherigen Ansprüche, wobei der Läufer (4) mit einem elektrostatischen Aktor (5) verbunden ist, wobei der elektrostatische Aktor (5) dazu eingerichtet ist, über eine Steuerspannung eine Offsetkompensation des Messsystems (1) einzustellen.

5. Messsystem nach Anspruch 4, wobei der elektrostatische Aktor (5) als symmetrischer elektrostatischer Kammantrieb mit Paaren von parallelen Plattenelektroden ausgebildet ist.

6. Messsystem nach einem der vorherigen Ansprüche, wobei der Läufer (4) mit einem mikromechanischen Verstärker (8) verbunden ist.

7. Messsystem nach Anspruch 6, wobei der mikromechanische Verstärker (8) eine eingangsseitige translatorische Bewegung mittels einer Reihenschaltung von Hebeln ausgangsseitig in eine Amplituden-verstärkte translatorische Verschiebung umwandelt.

8. Messsystem nach einem der vorherigen Ansprüche, wobei der Läufer (4) mittels Führungsfedern (10) gehalten wird.

9. Messsystem nach einem der vorherigen Ansprüche, wobei der elektromechanische Signalwandler (7) auf einer Kapazitätsänderung basiert.

10. Messsystem nach einem der vorherigen Ansprüche, wobei der Kraftgenerator (3) eine Feder ist.

11. Messsystem nach einem der vorherigen Ansprüche, wobei der Läufer (4) ein starres mechanisches Element ist.

12. Messsystem nach einem der vorherigen Ansprüche, umfassend einen Computer, welcher mit dem elektrostatischen Aktor (5) und/oder der elektrostatischen Anti-Feder (6) und/oder dem elektromechanischen Signalwandler (7) verbunden ist und dazu eingerichtet ist, die Offsetkompensation und/oder die Einstellung der Sensitivität durchzuführen.

13. Verfahren zur Anpassung der Sensitivität und/oder zur Anpassung des Messbereichs eines mikromechanischen Messsystems (1), umfassend die Schritte

   - Umwandeln eines physikalischen Signals in eine Verschiebung eines Energiewandlers (13) mittels des Energiewandlers (2),
   - Umwandeln der Verschiebung vom Energiewandler (2) in eine Kraft auf einen bewegbar gelagerten Läufer (4) mittels eines Kraftgenerators (3), und
   - Umwandeln der Verschiebung des Läufers (4) in ein elektrisches Signal mittels eines elektromechanischen Signalwandlers (7),

   wobei die Sensitivität des Messsystems (1) über eine Steuerspannung einer elektrostatischen Anti-Feder (4) eingestellt wird, welche mit dem Läufer (4) und/oder dem Kraftgenerator verbunden ist.

14. Verfahren nach vorherigem Anspruch, umfassend die Schritte

   - Messen mittels des mikromechanischem Messsystem (1),
   - Durchführung einer Offsetkompensation,
   - Erhöhung der Sensitivität und
   - wiederholtes Messen mittels des Messsystems (1).

15. Verwendung des mikromechanisches Messsystems nach einem der vorherigen Ansprüche in einem Dehnungssensor oder Beschleunigungssensor oder Temperatursensor.

**Claims**

1. Measuring system (1) based on micromechanical elements, comprising

   - an energy converter (13), which is configured to convert a physical signal into a displacement of the energy converter (13),
   - a force generator (3) which is configured to convert the displacement of the energy converter (13) into a force on a movably mounted slider (4), and
   - an electromechanical signal converter (7) which converts a displacement of the slider (4) into an electrical signal,

   **characterized in that**

   the measuring system (1) comprises an electrostatic anti-spring (6), which is mechanically connected to the slider (4),
   wherein the electrostatic anti-spring (6) is configured to adjust a sensitivity of the measuring system (1) via a control voltage.

2. Measuring system according to claim 1, wherein the electrostatic anti-spring (6) is bidirectional and/or has varying electrode spacings.

3. Measuring system according to claim 1 or 2, wherein the electrostatic anti-spring (6) is configured as a symmetrical electrostatic comb drive with pairs of curved and parallel plate electrodes.

4. Measuring system according to one of the preceding claims, wherein the slider (4) is connected to an electrostatic actuator (5), wherein the electrostatic actuator (5) is configured to adjust an offset compensation of the measuring system (1) via a control voltage.

5. Measuring system according to claim 4, wherein the electrostatic actuator (5) is configured as a symmetrical electrostatic comb drive with pairs of parallel plate electrodes.

6. Measuring system according to one of the preceding claims, wherein the slider (4) is connected to a micromechanical amplifier (8).

7. Measuring system according to claim 6, wherein the micromechanical amplifier (8) converts an input-side translatory movement into an amplitude-amplified translatory displacement on the output side by means of a series connection of levers.

8. Measuring system according to one of the preceding claims, wherein the slider (4) is held by means of guide springs (10).

9. The measuring system according to any one of the preceding claims, wherein the electromechanical signal converter (7) is based on a capacitance change.

10. Measuring system according to one of the previous claims, wherein the force generator (3) is a spring.

11. A measuring system according to any one of the preceding claims, wherein the slider (4) is a rigid mechanical element.

12. A measuring system according to any one of the preceding claims, comprising a computer which is connected to the electrostatic actuator (5) and/or the electrostatic anti-spring (6) and/or the electromechanical signal converter (7) and is configured to perform the offset compensation and/or the sensitivity adjustment.

13. Method for adjusting the sensitivity and/or for adjusting the measuring range of a micromechanical measuring system (1), comprising the steps of

   - Converting a physical signal into a displacement of an energy converter (13) by means of the energy converter (13),
   - Converting the displacement from the energy converter (13) into a force on a movably mounted slider (4) by means of a force generator (3), and
   - Converting the displacement of the slider (4) into an electrical signal by means of an electromechanical signal converter (7),

   wherein the sensitivity of the measuring system (1) is adjusted via a control voltage of an electrostatic anti-spring (4), which is connected to the slider (4) and/or the force generator.

14. A method according to the preceding claim, comprising the steps of

   - Measure using the micromechanical measuring system (1),
   - Performing out offset compensation,
   - Increase sensitivity and
   - repeated measurement using the measuring system (1).

15. Use of the micromechanical measuring system according to one of the preceding claims in a strain sensor or acceleration sensor or temperature sensor.


**Revendications**

1. Système de mesure (1) basé sur des éléments micromécaniques, comprenant

   - un convertisseur d'énergie (2), conçu pour convertir un signal physique en un déplacement du convertisseur d'énergie (2),

- un générateur de force (3) et un rotor mobile (4), conçus pour convertir le déplacement du convertisseur d'énergie (2) en une force exercée sur le rotor mobile (4), et
- un convertisseur de signal électromécanique (7), qui convertit un déplacement du rotor (4) en signal électrique,

**caractérisée en ce que**

le système de mesure (1) comprend un anti-ressort électrostatique (6), relié mécaniquement au rotor (4), dans lequel l'anti-ressort électrostatique (6) étant conçu pour régler la sensibilité du système de mesure (1) au moyen d'une tension de commande.

2.  Système de mesure selon revendication 1, dans lequel l'anti-ressort électrostatique (6) est bidirectionnel et/ou présente des espacements d'électrodes variables.

3.  Système de mesure selon la revendication 1 ou 2, dans lequel l'anti-ressort électrostatique (6) est conçu comme un entraînement à peigne électrostatique symétrique avec des paires d'électrodes à plaques courbes et parallèles.

4.  Système de mesure selon l'une des revendications précédentes, dans lequel le rotor (4) est connecté à un actionneur électrostatique (5), dans lequel l'actionneur électrostatique (5) étant conçu pour régler une compensation de décalage du système de mesure (1) au moyen d'une tension de commande.

5.  Système de mesure selon la revendication 4, dans lequel l'actionneur électrostatique (5) est conçu comme un entraînement à peigne électrostatique symétrique avec des paires d'électrodes à plaques parallèles.

6.  Système de mesure selon l'une des revendications précédentes, dans lequel le rotor (4) est connecté à un amplificateur micromécanique (8).

7.  Système de mesure selon revendication 6, dans lequel l'amplificateur micromécanique (8) convertit un mouvement de translation côté entrée en un déplacement de translation amplifié en amplitude côté sortie au moyen d'une connexion en série de leviers.

8.  Système de mesure selon l'une des revendications précédentes, dans lequel le rotor (4) est maintenu au moyen de ressorts de guidage (10).

9.  Système de mesure selon l'une des revendications précédentes, dans lequel le convertisseur de signal électromécanique (7) est basé sur une variation de capacité.

10. Système de mesure selon l'une des revendications précédentes, dans lequel le générateur de force (3) est un ressort.

11. Système de mesure selon l'une des revendications précédentes, dans lequel le rotor (4) est un élément mécanique rigide.

12. Système de mesure selon l'une des revendications précédentes, comprenant un ordinateur connecté à l'actionneur électrostatique (5) et/ou à l'anti-ressort électrostatique (6) et/ou au convertisseur de signal électromécanique (7) et conçu pour effectuer la compensation de décalage et/ou le réglage de la sensibilité.

13. Procédé de réglage de la sensibilité et/ou de la plage de mesure d'un système de mesure micromécanique (1), comprenant les étapes suivantes

- la conversion d'un signal physique en un déplacement d'un convertisseur d'énergie (13) au moyen du convertisseur d'énergie (2),
- la conversion du déplacement du convertisseur d'énergie (2) en une force sur un rotor mobile (4) au moyen d'un générateur de force (3), et
- la conversion du déplacement du rotor (4) en signal électrique au moyen d'un convertisseur de signal électromécanique (7),

dans lequel la sensibilité du système de mesure (1) étant réglée au moyen d'une tension de commande d'un anti-ressort électrostatique (4), qui est connecté au rotor (4) et/ou au générateur de force.

**14.** Procédé selon la revendication précédente, comprenant les étapes suivantes

- la mesure à l'aide du système de mesure micromécanique (1),
- la mise en œuvre de la compensation de décalage,
- l'augmentation de la sensibilité et
- des mesurer répétées à l'aide du système de mesure (1).

**15.** Utilisation du système de mesure micromécanique selon l'une des revendications précédentes dans un capteur de contrainte, un capteur d'accélération ou un capteur de température.

(I)

| 0 | 1 | 2 | 3 | 4 | 5 | 6 | 7 | 8 | 9 | 10 |

(II)

| 0 | 1 | 2 | 3 | 4 | 5 | 6 | 7 | 8 | 9 | 10 |

(III)

| 4,0 | 4,1 | 4,2 | 4,3 | 4,4 | 4,5 | 4,6 | 4,7 | 4,8 | 4,9 | 5 |

## Fig. 1

(I)

(II)

(III)

## Fig. 2

Fig. 3

Fig. 4

Fig. 5

Fig. 6

(A)

(B)

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3822577 A1